# EUROPEAN PATENT APPLICATION

(11) **EP 4 596 521 A1**
(43) Date of publication of application: **06.08.2025**
(21) Application number: 23871861.3
(22) Date of filing: 11.09.2023
(51) Int. Cl.: C04B 35/495, H10N 30/067, H10N 30/50, H10N 30/853

(54) **LEAD-FREE PIEZOELECTRIC COMPOSITION AND PIEZOELECTRIC ELEMENT**

(30) Priority: 30.09.2022 JP 2022158308
(71) Applicant: Niterra Co., Ltd., Nagoya-shi, Aichi 461-0005 (JP)
(72) Inventor: HIROSE, Yoshinobu, Nagoya-shi, Aichi 461-0005 (JP); ICHIHASHI, Kentaro, Nagoya-shi, Aichi 461-0005 (JP); YAMAZAKI, Masato, Nagoya-shi, Aichi 461-0005 (JP)
(74) Representative: Grünecker Patent- und Rechtsanwälte PartG mbB
(86) International application number: PCT/JP2023/033007
(87) International publication number: WO 2024/070625

(57) **Abstract**

A lead-free piezoelectric composition according to the present invention comprises a main phase containing an alkali niobate perovskite oxide, and a sub-phase containing a Mn-Ti-O oxide, the maximum particle diameter of the Mn-Ti-O oxide in the sub-phase being 35 µm or less, and the number-based cumulative 80% particle size (D80) being 32 µm or less.

## Description

### TECHNICAL FIELD

The present invention relates to a lead-free piezoelectric composition and to a piezoelectric element.

### BACKGROUND ART

Hitherto, many piezoelectric elements have been formed of a PZT (lead zirconate titanate) material. However, a lead component contained in PZT evokes a problematic impact on the environment. Thus, in recent years, development of piezoelectric elements formed of a lead-free material has been pursued.

As one example of such a lead-free material, there has been proposed a lead-free piezoelectric composition containing a primary phase which is a first crystalline phase formed of an alkali niobate perovskite-type oxide, and a secondary phase containing second crystals formed of an M-Ti-O spinel compound (in which element M represents a monovalent to tetravalent element) (see Patent Document 1).

The alkali niobate perovskite-type oxide forming the primary phase *per se* is a substance in which voids are readily provided, and the voids impair piezoelectric characteristics. By filling the voids in the primary phase with the secondary phase containing second crystals, the structure of the primary phase (first crystalline phase) is stabilized. Thus, the aforementioned lead-free piezoelectric composition is excellent in piezoelectric characteristics. Specifically, when force is applied to the lead-free piezoelectric composition, voltage is generated, whereas when voltage is applied, the lead-free piezoelectric composition undergoes dimensional contraction and change in shape.

### CITATION LIST

### PATENT LITERATURE

Patent Literature 1: JP 5715309B

### (Problems to be Solved by the Invention)

Although the aforementioned lead-free piezoelectric composition is excellent in piezoelectric characteristics, the breakdown voltage is low, causing a problem in insulation property.

### SUMMARY OF INVENTION

An object of the present invention is to provide a lead-free piezoelectric composition which is excellent in piezoelectric characteristics and insulation property, and the like.

### (Means for Solving the Problems)

The means for solving the aforementioned problem is as follows. <1> A lead-free piezoelectric composition having a primary phase containing an alkali niobate perovskite-type oxide and a secondary phase containing an Mn-Ti-O oxide, in which the Mn-Ti-O oxide contained in the secondary phase has a maximum grain size of 35 µm or smaller and a number-basis 80% cumulative particle size (D80) of 32 µm or smaller.

<2> The lead-free piezoelectric composition according to <1> above, in which the Mn-Ti-O oxide contained in the secondary phase has a mean grain size of 24 µm or smaller.

<3> The lead-free piezoelectric composition according to <1> or <2> above, in which the Mn-Ti-O oxide includes MnTi₂O₄ or Mn₂TiO₄.

<4> A piezoelectric element having a stacked body of a piezoelectric ceramic layer formed of a lead-free piezoelectric composition as recited in any one of <1> to <3> above, and an electrode attached to the piezoelectric ceramic layer.

### (Advantageous Effects of the Invention)

According to the present invention, a lead-free piezoelectric composition which is excellent in piezoelectric characteristics and insulation property, and the like can be provided.

### BRIEF DESCRIPTION OF DRAWINGS

[FIG. 1] Perspective view of a piezoelectric element of embodiment 1.
[FIG. 2] Cross-section of a piezoelectric element of embodiment 2.

### DESCRIPTION OF EMBODIMENTS

Hereinafter, the lead-free piezoelectric composition and the piezoelectric element according to an embodiment will be described.

The lead-free piezoelectric composition has a primary phase containing an alkali niobate perovskite-type oxide and a secondary phase containing an Mn-Ti-O oxide.

The primary phase is formed of a first crystalline phase formed of an alkali niobate perovskite-type oxide. The alkali niobate perovskite-type oxide is represented by the following compositional formula (1).

(A1ₐM1_{b})_{c}(Nb_{d1}Mn_{d2}Ti_{d3}Zr_{d4})O₃₊ₑ ··· (1)

The element A1 is an alkali metal which is at least one species of Li, Na, and K. The element M1 is an alkaline earth metal which is at least one species of Ba (barium), Ca (calcium), and Sr (strontium).

In the above compositional formula (1), the element A1 and the element M1 are disposed in A sites of the perovskite structure, and Nb (niobium), Mn (manganese), Ti (titanium), and Zr (zirconium) are disposed in B sites.

In the compositional formula (1), coefficients a to e are selected from the values which are preferred from the viewpoints of electrical characteristics and piezoelectric characteristics (in particular, piezoelectric constant d₃₃) of the lead-free piezoelectric composition, so long as the coefficients a to e ensure establishment of the perovskite structure.

Specifically, coefficients a and b satisfy the conditions: 0<a<1, 0<b<1, and a+b=1. However, the cases of a=0 (i.e., the composition containing no alkali metal) and b=0 (i.e., the composition containing none of Ca, Sr, and Ba) are excluded.

Coefficient c with respect to the entire A sites satisfies 0.80<c<1.10, and is preferably 0. 84≤c≤1.08, more preferably 0.88≤c≤1.07.

Coefficients d1, d2, d3, and d4 satisfy the conditions: 0<d1<1, 0<d2<1, 0<d3<1, 0≤d4<1, and d1+d2+d3+d4=1. However, the cases of d1=0 (i.e., the composition containing no Nb), d2=0 (i.e., the composition containing no Mn), and d3=0 (i.e., the composition containing no Ti or Zr) are excluded. Coefficient d4 to Zr may be 0 (i.e., any composition containing no Zr being acceptable).

In coefficient (3+e) with respect to oxygen, the value of e is a positive or negative value showing deficiency or excess from the intrinsic value of 3 with respect to oxygen. Coefficient (3+e) with respect to oxygen may be a value which allows the primary phase to have a perovskite oxide structure. Typically, coefficient e is 0, and preferably satisfies 0≤e≤0.1. Notably, coefficient e may also be calculated from the composition of the primary phase to meet the electrically neutral condition. However, needless to say, a composition of the primary phase which is slightly deviated from the electrically neutral condition is also allowable.

Among the alkali niobate perovskite-type oxides represented by the aforementioned compositional formula (1), those containing K, Na, and Nb as main metallic components are called "KNN" or "KNN material" and exhibit excellent properties such as piezoelectric and electric characteristics.

Notably, the aforementioned compositional formula (1) can be transformed into the following compositional formula (1A).

(Kₐ₁Naₐ₂Liₐ₃Ca_{b1}Sr_{b2}Ba_{b3})_{c}(Nb_{d1}Mn_{d2}Ti_{d3}Zr_{d4})O₃₊ₑ ··· (1A)

The aforementioned compositional formula (1) is equivalent to the above formula (1A), and the conditions: a1+a2+a3=a and b1+b2+b3=b are satisfied. Coefficients a1 and a2 with respect to K and Na satisfy the conditions: 0<a1≤0.6 and 0<a1≤0.6, respectively. Coefficient a3 with respect to Li is 0≤a3≤0.2 (preferably 0≤a3≤0.1).

The secondary phase is formed of a second crystalline phase containing Mn-Ti-O oxide. The Mn-Ti-O oxide is an oxide containing Mn (manganese) and Ti (titanium) and is represented by, for example, the following compositional formula (2).

MnTiO_{y} ··· (2)

Coefficient y satisfies 2≤y≤8.

Mn-Ti-O oxide may be MnTi₂O₄.

Mn-Ti-O oxide may be Mn₂TiO₄.

Notably, the Mn composition and the Ti composition of Mn-Ti-O oxide (e.g., MnTi₂O₄, or Mn₂TiO₄) may vary from the target value within a range of ±0.2.

So long as the object of the present invention is not impaired, the lead-free piezoelectric composition of the present embodiment may include an additional crystalline phase (e.g., a third crystalline phase) other than the second crystalline phase.

In the lead-free piezoelectric composition of the present embodiment, the maximum grain size of the Mn-Ti-O oxide in the secondary phase is 35 µm or smaller. The maximum grain size of the Mn-Ti-O oxide is determined through the method mentioned below.

Also in the lead-free piezoelectric composition of the present embodiment, the number-basis 80% cumulative particle size (D80) of the Mn-Ti-O oxide in the secondary phase is 32 µm or smaller. The number-basis 80% cumulative particle size (D80) is determined through the method mentioned below.

When the maximum grain size of Mn-Ti-O oxide in the secondary phase and the number-basis 80% cumulative particle size (D80) of Mn-Ti-O oxide in the secondary phase fall within the above ranges, a lead-free piezoelectric composition which exhibits excellent piezoelectric characteristics and excellent insulation property (i.e., high breakdown voltage) can be provided.

In the lead-free piezoelectric composition of the present embodiment, the mean grain size of Mn-Ti-O oxide in the secondary phase is preferably 24 µm or smaller. The mean grain size of the Mn-Ti-O oxide is determined through the method mentioned below.

When the mean grain size of Mn-Ti-O oxide in the secondary phase falls within the above range, the piezoelectric characteristics and insulation property of the lead-free piezoelectric composition can be easily improved.

The secondary phase including the second crystalline phase satisfying the above conditions is provided in a dispersed manner in the primary phase formed of the first crystalline phase. The secondary phase buries the voids (space) provided between minute crystals of the primary phase. Although the secondary phase has no piezoelectric characteristic, the co-presence of the secondary phase with the primary phase results in improvement in sinterability and structural stability as well as insulation property of the lead-free piezoelectric composition.

In the present embodiment, no particular limitation is imposed on the relative amount of the secondary phase in the lead-free piezoelectric composition, so long as the object of the present invention is not impaired. The secondary phase content is preferably, for example, 0.5 vol.% or more and 5 vol.% or less.

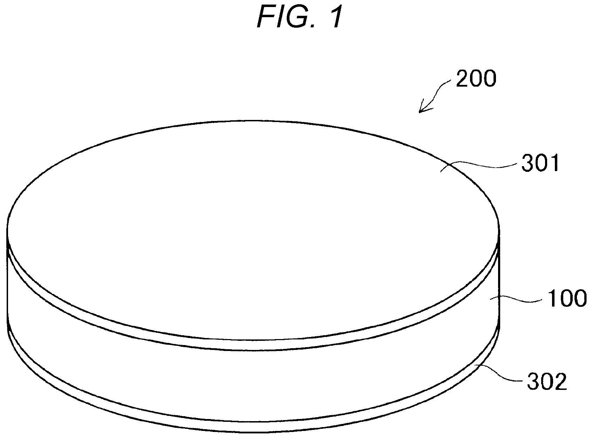

Next, a piezoelectric element 200 according to embodiment 1 will be described, with reference to FIG. 1. FIG. 1 is a perspective view of a piezoelectric element 200 of embodiment 1. As shown in FIG. 1, the piezoelectric element 200 of the present embodiment has a disk shape in appearance, and includes a disk-shape piezoelectric layer (an example of the piezoelectric ceramic layer) 100, an electrode 301 disposed on one surface of the piezoelectric layer 100, and an electrode 302 disposed on the other surface. The piezoelectric layer 100 is formed from the aforementioned lead-free piezoelectric composition. The piezoelectric layer 100 is polarized toward the thickness direction. The electrodes 301, 302 are formed of, for example, Au.

An example of the method of producing the aforementioned piezoelectric element 200 according to embodiment 1 will next be described. First, a plurality of essential ingredients for producing a primary phase are chosen from powder-form raw materials, and weighed so as to attain a target composition. The powder-form raw materials may be an oxide, a carbonate salt, a hydroxide, or the like of an element forming the primary phase. To the thus-weighed powder raw materials, ethanol is added, and the mixture is subjected to wet mixing by means of a ball mill preferably for 15 hours or longer, to thereby yield a slurry. The thus-obtained slurry was dried to form a powder mixture, and the powder is calcined under the conditions, for example, 600 to 1,000°C in air for 1 to 10 hours, to thereby obtain a powder-form primary phase calcined product.

Separately, a plurality of essential ingredients for producing the secondary phase are chosen from powder-form raw materials, and weighed so as to attain a target composition. The powder-form raw materials may be an oxide, a carbonate salt, a hydroxide, or the like of an element forming the secondary phase. To the thus-weighed powder-form raw materials, ethanol is added, and the mixture is subjected to wet mixing by means of a ball mill for preferably 15 hours or longer, to thereby prepare a slurry. The thus-prepared slurry is dried, and the dry powder mixture is calcined at, for example, 600 to 1,000°C in air for 1 to 10 hours, to thereby yield a powder-form secondary phase calcined product.

Subsequently, the primary phase calcined product and the secondary phase calcined product are mixed with a dispersant, a binder and ethanol, and the mixture is pulverized and mixed, to thereby give a slurry. The thus-obtained slurry is dried, and the product is suitably granulated and monoaxially pressed at a pressure, for example, 20 MPa, to thereby provide a preliminary compact of a disk shape. The thus-obtained preliminary compact is subjected to a cold isostatic pressing (CIP) treatment at, for example, 150 MPa, to thereby yield a compact.

Then, the thus-obtained compact is maintained at, for example, 200 to 400°C for 2 to 10 hours, to thereby effect debinding. The thus-debindered compact is fired at, for example, 1,000 to 1,200°C in a pressure-controlled reducing atmosphere (a pressure controlled to a reduction side from Ni/NO equilibrium oxygen partial pressure by order of 1 or greater) for 2 to 5 hours, to thereby form a piezoelectric layer.

On each surface of the formed piezoelectric layer, an Au electrode is formed through, for example, sputtering. Subsequently, the stacked body having the piezoelectric layer equipped with the electrodes is placed in silicone oil at 50°C and subjected to polarization treatment by applying a DC voltage of 5 kv/mm, to thereby generate a voltage characteristic of the piezoelectric layer. Thus, the piezoelectric element 200 is yielded.

Notably, in the lead-free piezoelectric composition employed in the voltage element 200, the secondary phase is formed of a second crystalline phase containing Mn-Ti-O oxide, as mentioned above. In the secondary phase, the dimensions of the crystal grains (e.g., maximum grain size, D80, and mean grain size) can be adjusted to desired values by appropriately tuning the particle size of the secondary phase calcined product and temperature of firing the debindered compact in a reducing atmosphere. For example, as the particle size of the secondary phase calcined product increases, the crystal grain size of the secondary phase of the finally obtained lead-free piezoelectric composition increases. Also, the particle size of the secondary phase calcined product and temperature of firing the debindered compact in a reducing atmosphere increases, the crystal grain size of the secondary phase of the finally obtained lead-free piezoelectric composition increases.

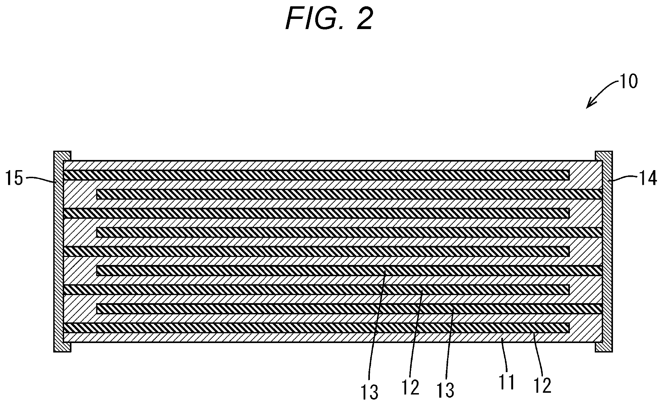

With reference to FIG. 2, a piezoelectric element 10 according to embodiment 2 will next be described in detail. FIG. 2 is a cross-section of the piezoelectric element 10 according to embodiment 2. As shown in FIG. 2, the piezoelectric element 10 of the present embodiment has a piezoelectric layer (an example of the voltage ceramic layer) 11, a plurality of inner electrodes 12, 13 which are in contact with the piezoelectric layer 11, and two outer electrodes 14, 15 which are connected to the inner electrodes 12, 13. The piezoelectric layer 11 is formed of the aforementioned lead-free piezoelectric composition. The inner electrodes 12, 13 are predominantly formed of a base metal (e.g., nickel). The piezoelectric layer 11 and the inner electrodes 12, 13 are alternatingly stacked. More specifically, the piezoelectric layer 11 and the inner electrodes 12, 13 are stacked, for example, in an order of the piezoelectric layer 11, the inner electrode 12, the piezoelectric layer 11, the inner electrode 13, and the piezoelectric layer 11. One piezoelectric layer 11 is sandwiched by two inner electrodes 12, 13. The two outer electrodes 14, 15 are disposed on the outer surface of the stacked body of the piezoelectric layer 11 and the inner electrodes 12, 13. The outer electrodes 14, 15 are predominantly formed of, for example, Au. Among the two inner electrodes 12, 13 in contact with the one piezoelectric layer 11, an end of the inner electrode 12 is connected to the outer electrode 14, and an end of the inner electrode 13 is connected to the outer electrode 15. Through application of a voltage between the outer electrodes 14, 15, the piezoelectric layer 11 expands and contract, whereby the piezoelectric element 10 in entirety expands and contracts.

An example of the method of producing the piezoelectric element 10 according to embodiment 2 will next be described. First, a plurality of essential ingredients for producing a primary phase are chosen from powder-form raw materials, and weighed so as to attain a target composition. The powder-form raw materials may be an oxide, a carbonate salt, a hydroxide, or the like of an element forming the primary phase. To the thus-weighed powder raw materials, ethanol is added, and the mixture is subjected to wet mixing by means of a ball mill preferably for 15 hours or longer, to thereby yield a slurry. The slurry was dried to form a powder mixture, and the powder is calcined under the conditions, for example, 600 to 1,000°C in air for 1 to 10 hours, to thereby obtain a powder-form primary phase calcined product.

Separately, a plurality of essential ingredients for producing the secondary phase are chosen from powder-form raw materials, and weighed so as to attain a target composition. The powder-form raw materials may be an oxide, a carbonate salt, a hydroxide, or the like of an element forming the secondary phase. To the thus-weighed powder-form raw materials, ethanol is added, and the mixture is subjected to wet mixing by means of a ball mill for preferably 15 hours or longer, to thereby prepare a slurry. The thus-prepared slurry is dried, and the dry powder mixture is calcined at, for example, 600 to 1,000°C in air for 1 to 10 hours, to thereby yield a powder-form secondary phase calcined product.

Subsequently, the primary phase calcined product and the secondary phase calcined product are mixed with a dispersant, a binder, and an organic solvent (e.g., toluene), and the mixture is pulverized and mixed, to thereby give a slurry. Then, the thus-obtained slurry is formed into a sheet through a doctor blade method or the like, to thereby produce a ceramic green sheet.

Then, an electrode layer serving as an inner electrode is formed on a surface of the ceramic green sheet by use of a conductive paste for forming an inner electrode through, for example, screen printing. The electrode layer is predominantly formed of a base metal (e.g., nickel (Ni)).

Next, a plurality of ceramic green sheets each provided with an electrode layer are stacked such that the electrode layers are exposed in an alternating manner, and ceramic green sheets each provided with no electrode layer are stacked on each surface of the stacked body. The thus-obtained stacked bodies are press-bonded, to thereby yield a stacked body in which ceramic green sheets and electrode layers have been alternatingly stacked. The resultant stacked body is cut into a shape of interest, and then maintained at a temperature, for example, 200 to 400°C for 2 to 10 hours, to thereby perform debindering.

Next, the debindered stacked body is maintained for firing at a temperature, for example, 1,000 to 1,200°C in a pressure-controlled reducing atmosphere (a pressure controlled to a reduction side from Ni/NO equilibrium oxygen partial pressure by order of 1 or greater) for 2 to 5 hours.

A side surface of the thus-fired stacked body is appropriately polished, and a pair of outer electrodes formed of Au are formed on the side surface of the stacked body through sputtering or a similar technique. The pair of outer electrodes are formed such that they sandwich the stacked body and oppositely face each other. The stacked body equipped with the outer electrodes is subjected to a polarization treatment, to thereby yield the piezoelectric element 10.

Notably, in the lead-free piezoelectric composition employed in the voltage element 10, the secondary phase is formed of a second crystalline phase containing Mn-Ti-O oxide, as mentioned above. In the secondary phase, the dimensions of the crystal grains (e.g., maximum grain size, D80, and mean grain size) can be adjusted to desired values by appropriately tuning the particle size of the secondary phase calcined product and temperature of firing the debindered compact in a reducing atmosphere. For example, as the particle size of the secondary phase calcined product increases, the crystal grain size of the secondary phase of the finally obtained lead-free piezoelectric composition increases. Also, as the particle size of the secondary phase calcined product and temperature of firing the debindered compact in a reducing atmosphere increases, the crystal grain size of the secondary phase of the finally obtained lead-free piezoelectric composition increases.

Notably, the production methods of embodiments 1 and 2 as described above are a merely an exemplary method, and various other steps and treatment conditions for producing a piezoelectric element may be employed. For example, instead that a calcined product of the primary phase and that of the secondary phase are separately formed in advance, and the two powder products are mixed, followed by firing, raw materials of the primary phase and those of the secondary phase may be mixed at such a ratio that the target compositional proportions of the finally obtained lead-free piezoelectric composition are attained, followed by firing the thus-prepared mixture. However, through the former method (i.e., separately forming a calcined product of the primary phase and that of the secondary phase in advance and mixing the two products), rigorous control of the composition of the primary phase and that of the secondary phase can be easily achieved, whereby the yield of the lead-free piezoelectric composition can be enhanced. Also, the material used for forming the electrode may be a metal or an alloy such as platinum (Pt), silver-palladium (Ag-Pd), or silver (Ag).

The lead-free piezoelectric composition and the piezoelectric element disclosed in the present specification exhibit excellent piezoelectric characteristic, high breakdown voltage, and excellent insulation property. Such a lead-free piezoelectric composition and a piezoelectric element find various uses including vibration sensing, pressure sensing, oscillation, and piezoelectric devices. Examples of the possible use include sensors for detecting various vibrations (e.g., a knocking sensor and a combustion pressure sensor); piezoelectric devices such as an oscillator, an actuator, and a filter; high-voltage generators; micro power supplies; driving units; position control systems; vibration dampers; and fluid discharge systems (e.g., a paint ejector and a fuel ejector).

### EXAMPLES

The present invention will next be described in detail by way of example, which should not be construed as limiting the invention thereto.

### [Examples 1 to 7]

### (Preparation of primary phase calcined product)

K₂CO₃ powder, Na₂CO₃ powder, Nb₂O₅ powder, TiO₂ powder, ZrO₂ powder, MnCO₃ powder, and BaCO₃ powder were provided as raw material powders. These powders were weighed so that the element contents (mol%) were adjusted to the values shown in Table 1. To a mixture of the thus-weighed raw material powders, an appropriate amount of ethanol was added, and the resultant mixture was wet-mixed by means of a ball mill for 15 hours, to thereby prepare a slurry. The slurry was dried to provide a powder-form mixture, and the mixture was calcined in air at 600 to 1,100°C for 1 to 10 hours, to thereby yield a primary phase calcined product.

### (Preparation of secondary phase calcined product)

MnCO₃ powder and TiO₂ powder were provided as raw material powders. These powders were weighed so as to achieve the composition (MnTi₂O₄) shown in Table 2. To a mixture of the thus-weighed raw material powders, an appropriate amount of ethanol was added, and the resultant mixture was wet-mixed by means of a ball mill for 15 hours, to thereby prepare a slurry. The slurry was dried to provide a powder-form mixture, and the mixture was calcined in air at 600 to 1,100°C for 1 to 10 hours, to thereby yield a secondary phase calcined product.

### (Fabrication of piezoelectric element)

The primary phase calcined product and the secondary phase calcined product prepared above were mixed with a dispersant, a binder and ethanol, and the mixture was pulverized and mixed, to thereby give a slurry. The thus-obtained slurry was dried, and the product was suitably granulated and monoaxially pressed at 20 MPa, to thereby provide a preliminary compact of a disk shape. The thus-obtained preliminary compact was subjected to a cold isostatic pressing (CIP) treatment at a pressure of 150 MPa, to thereby yield a compact. Notably, the primary phase calcined product and the secondary phase calcined product were mixed so as to adjust the ratio (vol%) of primary phase to secondary phase to 97:3.

The thus-obtained compact was maintained at 200 to 400°C for 2 to 10 hours, to thereby effect debindering. The thus-debindered compact was fired at 1,000 to 1,200°C in a pressure-controlled reducing atmosphere (a pressure controlled to a reduction side from Ni/NO equilibrium oxygen partial pressure by order of 1 or greater) for 2 to 5 hours, to thereby form a piezoelectric layer.

On each surface of the formed piezoelectric layer, an Au electrode was formed through sputtering. Subsequently, the stacked body having the piezoelectric layer equipped with the electrodes was placed in silicone oil at 50°C and subjected to polarization treatment by applying a DC voltage of 5 kV/mm, to thereby generate a voltage characteristic of the piezoelectric layer. Thus, a piezoelectric element of each Example was fabricated.

Notably, the particle size of the secondary phase calcined product and the firing temperature of the compact in a reducing atmosphere after debindering were appropriately modified to vary between Examples 1 to 7.

### [Comparative Example 1]

The procedure of Example 7 or the like was repeated, except that the particle size of the secondary phase calcined product was adjusted to be greater than the particle size employed in Example 7, and the firing temperature of the compact in a reducing atmosphere after debindering was adjusted to be higher than the firing temperature employed in Example 7, to thereby fabricate a piezoelectric element of Comparative Example 1.

### [Comparative Example 2]

The same primary phase calcined product as employed in Example 1 was provided. The secondary phase calcined product was produced through the following procedure. Specifically, the procedure of Example 1 or the like was repeated, except that Li₂CO₃ powder and TiO₂ powder were provided as raw material powders, and these powders were weighed so as to achieve the composition (LiTi₂O₄) shown in Table 3, to thereby produce the secondary phase calcined product. By use of the primary phase calcined product and the secondary phase calcined product, in a manner similar to Example 1 or the like, a piezoelectric element of Comparative Example 2 was fabricated.

### [Comparative Example 3]

The same primary phase calcined product as employed in Example 1 was provided. The secondary phase calcined product was produced through the following procedure. Specifically, the procedure of Example 1 or the like was repeated, except that Li₂CO₃ powder, Fe₂O₃ powder, MgO powder, and TiO₂ powder were provided as raw material powders, and these powders were weighed so as to achieve the composition (LiFeMgTiO₄) shown in Table 3, to thereby produce the secondary phase calcined product. By use of the primary phase calcined product and the secondary phase calcined product, in a manner similar to Example 1 or the like, a piezoelectric element of Comparative Example 3 was fabricated.

### [Piezoelectric constant d₃₃]

The piezoelectric constant (pC/N) of each of the piezoelectric elements (piezoelectric layers) of Example 3 and Comparative Examples 2 and 3 was measured by means of a d₃₃ meter (ZJ-4B, product of Institute of Acoustics, Chinese Academy of Sciences). Table 3 shows the results.

### [Breakdown voltage]

The breakdown voltage (kV/mm) of each of the voltage elements of the Examples and the Comparative Examples was determined through the following procedure. Specifically, the voltage element was placed in silicone oil at 25°C, and a DC voltage (1 kV/mm) was applied for 1 minute. Subsequently, the applied voltage was stepwise elevated by 1 kV/mm, with each DC voltage being applied for 1 minute. When the voltage element was broken, the applied voltage (kV/mm) at the breakdown was employed as a breakdown voltage (breakdown electric field) of the voltage element. Tables 2 and 3 show the results.

### [Analysis of primary phase]

Primary phase composition analysis of each of the voltage elements (piezoelectric layers) of the Examples and the Comparative Examples was performed by means of an electron probe microanalyzer (EPMA) through the following procedure. Specifically, the piezoelectric layer of the piezoelectric element was cut along the thickness direction, and the cut surface was polished. The polished surface was observed by means of an EPMA at a magnification of 5,000, and an image was taken. In the obtained image, three crystal grains in the primary phase were selected at random, and the selected three crystal grains were quantitatively analyzed. The element contents at three crystal grains were averaged, and the average value was employed as the element content (mol%). Table 1 shows the results.

### [Analysis of secondary phase]

The secondary phase qualitative analysis of each of the voltage elements (piezoelectric layers) of the Examples and the Comparative Examples was performed by means of an electron probe microanalyzer (EPMA) through the following procedure. In each Example, the same polished surface of the piezoelectric layer as observed for the primary phase analysis was also observed by means of an EPMA at a magnification of 5,000, and an image was taken. The obtained image was subjected to element mapping in terms of Mn (manganese) and Ti (titanium). From the obtained element mapping image, the presence of Mn and Ti in the secondary phase was confirmed. In the case of Comparative Example 2, element mapping was performed in terms of Li (lithium), Fe (iron), Mg (magnesium), and Ti (titanium), and the presence of Li, Fe, Mg, and Ti was confirmed in the secondary phase from the obtained element mapping image. In the case of Comparative Example 3, element mapping was performed in terms of Mn (mangaese) and Ti (titanium), and the presence of Mn and Ti was confirmed in the secondary phase from the obtained element mapping image.

The aforementioned polished surface of each of the Examples and the Comparative Examples was analyzed through powder X-ray diffractometry (XRD: X-ray diffraction), to thereby identify the composition of a compound included in the secondary phase. Conditions for XRD measurement are as follows.

### <XRD measurement conditions>

Apparatus: powder X-ray diffractometer
Range: 50.00° to 70.00°
Wavelength: 0.7 angstroms

### [Grain sizes (maximum grain size, mean grain size, and D80) of crystal grains of secondary phase]

The aforementioned polished surface of each of the Examples and the Comparative Examples was observed under a scanning electron microscope (SEM) at a magnification of 1,000 or 10,000, and an image was taken. In the obtained SEM image (i.e., reflected electron image), a square (250 µm × 250 µm) for measurement was placed. A plurality of crystal grains present in the measurement square were analyzed by image analysis software, to thereby determine a long-axis diameter and a short-axis diameter. In one crystal grain, the long-axis diameter and the short-axis diameter cross at right angle. The values of long-axis diameter and short-axis diameter are the maximum values along the corresponding axis. The average value of the long-axis diameter and short-axis diameter of the crystal grain was employed as a grain size of each crystal grain. The thus-obtained average grain size of the crystal grain falling within the aforementioned measurement range was employed as a mean grain size (µm) of the crystal grains of the secondary phase.

Notably, the magnification of taking the SEM image was firstly set to 1,000. Then, when the crystal grains were not clearly identified from the obtained image, the magnification was modulated to 10,000. As a result, an SEM image was obtained at a magnification of 10,000 only in the case of Example 1, and at a magnification of 1,000 in the other cases for taking images.

Also, among the crystal grains observed within the aforementioned measurement range, the largest long-axis diameter was employed as the maximum grain size (µm) of the crystal grain in the secondary phase. Tables 2 and 3 show the results.

In addition, regarding the crystal grains observed within the aforementioned measurement range, a grain size distribution from the small size was drawn. On the basis of the grain size distribution, the number-basis 80% cumulative particle size (D80) was determined. Tables 2 and 3 show the results.

**[Table 1]**

| Primary Phase | | | | | | | |
|---|---|---|---|---|---|---|---|
| Element | A1 | | M1 | Nb | Mn | Ti | Zr |
| | K | Na | Ba | | | | |
| Coefficient | a | | b | d | | | |
| | a1 | a2 | b3 | d1 | d2 | d3 | d4 |
| | 0.47 | 0.51 | 0.02 | 0.951 | 0.014 | 0.014 | 0.021 |
| Content (mol%) | 23.7 | 26 | 1 | 46.9 | 0.7 | 1 | 1 |

**[Table 2]**

| | Secondary phase composition | Metal in secondary phase | Max. grain size (µm) | Mean grain size (µm) | D80 (µm) | Breakdown voltage (kV/mm) |
|---|---|---|---|---|---|---|
| Ex. 1 | MnTi₂O₄ | Mn, Ti | 0.5 | 0.3 | 0.4 | 21 |
| Ex. 2 | MnTi₂O₄ | Mn, Ti | 2 | 1 | 1.7 | 18 |
| Ex. 3 | MnTi₂O₄ | Mn, Ti | 11 | 7 | 10 | 20 |
| Ex. 4 | MnTi₂O₄ | Mn, Ti | 20 | 13 | 18 | 17 |
| Ex. 5 | MnTi₂O₄ | Mn, Ti | 27 | 19 | 22 | 18 |
| Ex. 6 | MnTi₂O₄ | Mn, Ti | 31 | 20 | 27 | 16 |
| Ex. 7 | MnTi₂O₄ | Mn, Ti | 35 | 24 | 32 | 16 |
| Comp. 1 | MnTi₂O₄ | Mn, Ti | 42 | 29 | 37 | 13 |

**[Table 3]**

| | Secondary phase composition | Metal in secondary phase | Max. grain size (µm) | Mean grain size (µm) | D80 (µm) | Breakdown voltage (kV/mm) | Piezoelectric constant d₃₃ (pC/N) |
|---|---|---|---|---|---|---|---|
| Comp. 2 | LiTi₂O₄ | Li, Ti | 12 | 6 | 10 | 10 | 200 |
| Comp. 3 | LiFeMgTiO₄ | Li, Fe, Mg, Ti | 14 | 8 | 12 | 12 | 180 |
| Ex. 3 | MnTi₂O₄ | Mn, Ti | 11 | 7 | 10 | 20 | 190 |

As is clear from Table 2, the lead-free piezoelectric compositions employed in the piezoelectric elements of Examples 1 to 7 each have a secondary phase formed of MnTi₂O₄ (Mn-Ti-O oxide). In Examples 1 to 7, the crystal grains in the secondary phase have a maximum grain size of 35 µm or smaller and a number-basis 80% cumulative particle size (D80) of 32 µm or smaller. In Examples 1 to 7, breakdown voltage is 16 kV/mm or higher. Thus, excellent insulation property has been confirmed.

Also, as is clear from Table 3, according to the results of piezoelectric constant measurement of Example 3 (representative case of the Examples), the lead-free piezoelectric compositions employed in the piezoelectric elements of Example 3 and other Examples have been found to exhibit excellent piezoelectric characteristics.

In Comparative Example 1, a secondary phase formed of MnTi₂O₄ (Mn-Ti-O oxide) is present, but the crystal grains in the secondary phase have a maximum grain size of 29 µm and a number-basis 80% cumulative particle size (D80) of 37 µm, which are excessively large. In such Comparative Example 1, the breakdown voltage is 13 kV/mm. Thus, poor insulation property has been confirmed.

In Comparative Example 2, the secondary phase contains Ti (titanium) but no Mn (manganese); i.e., the case of a secondary phase containing the compound (LiTi₂O₄). Similar to Example 3 and other Examples, excellent piezoelectric characteristics are achieved in Comparative Example 2, but the breakdown voltage is 10 kV/mm. Thus, poor insulation property has been confirmed.

Also, in Comparative Example 3, the secondary phase contains Ti (titanium) but no Mn (manganese); i.e., the case of a secondary phase containing the compound (LiFeMgTiO₄). Similar to Example 3 and other Examples, excellent piezoelectric characteristics are achieved in Comparative Example 3, but the breakdown voltage is 12 kV/mm. Thus, poor insulation property has been confirmed.

### [Examples 8 to 10]

The same primary phase calcined product as employed in Example 1 was provided. The secondary phase calcined product was produced through the following procedure. Specifically, MnCO₃ powder and TiO₂ powder were provided as raw material powders. These powders were weighed so as to achieve the composition (Mn₂TiO₄) shown in Table 2. To a mixture of the thus-weighed raw material powders, an appropriate amount of ethanol was added, and the resultant mixture was wet-mixed by means of a ball mill for 15 hours, to thereby prepare a slurry. The slurry was dried to provide a powder-form mixture, and the mixture was calcined in air at 600 to 1,100°C for 1 to 10 hours, to thereby yield a secondary phase calcined product. By use of the primary phase calcined product and the secondary phase calcined product, piezoelectric elements of Examples 8 to 10 were fabricated in a manner similar to that of Example 1 or other Examples.

Each of the piezoelectric elements of Examples 8 to 10 was subjected to the same analyses and measurement as conducted in Example 1 or other Examples; i.e., primary phase analysis, secondary phase analysis, breakdown voltage (kV/mm) measurement, and grain size determination of crystal grains in the secondary phase (maximum grain size, mean grain size, and D80). Table 4 shows the results.

**[Table 4]**

| | Secondary phase composition | Metal in secondary phase | Max. grain size (µm) | Mean grain size (µm) | D80 (µm) | Breakdown voltage (kV/mm) |
|---|---|---|---|---|---|---|
| Ex. 8 | Mn₂TiO₄ | Mn, Ti | 15 | 7 | 11 | 18 |
| Ex. 9 | Mn₂TiO₄ | Mn, Ti | 0.6 | 0.3 | 0.5 | 21 |
| Ex. 10 | Mn₂TiO₄ | Mn, Ti | 32 | 22 | 30 | 16 |

As is clear from Table 4, the lead-free piezoelectric compositions employed in the piezoelectric elements of Examples 8 to 10 each has a secondary phase formed of Mn₂TiO₄ (Mn-Ti-O oxide). In Examples 8 to 10, the crystal grains in the secondary phase have a maximum grain size of 35 µm or smaller and a number-basis 80% cumulative particle size (D80) of 32 µm or smaller. In Examples 8 to 10, breakdown voltage is 16 kV/mm or higher. Thus, excellent insulation property has been confirmed.

### REFERENCE SIGNS LIST

10, 200: piezoelectric element
11, 100: piezoelectric layer (piezoelectric ceramic layer)
12, 13: inner electrode
14, 15: outer electrode
301, 302: electrode

## Claims

1. A lead-free piezoelectric composition comprising
a primary phase containing an alkali niobate perovskite-type oxide, and
a secondary phase containing an Mn-Ti-O oxide,
wherein the Mn-Ti-O oxide contained in the secondary phase has a maximum grain size of 35 µm or smaller and a number-basis 80% cumulative particle size (D80) of 32 µm or smaller.

2. A lead-free piezoelectric composition according to claim 1, wherein the Mn-Ti-O oxide contained in the secondary phase has a mean grain size of 24 µm or smaller.

3. A lead-free piezoelectric composition according to claim 1 or 2, wherein the Mn-Ti-O oxide includes MnTi₂O₄ or Mn₂TiO₄.

4. A piezoelectric element comprising a stacked body of a piezoelectric ceramic layer formed of a lead-free piezoelectric composition as recited in claim 1 or 2, and an electrode attached to the piezoelectric ceramic layer.
